(19) Europäisches Patentamt
European Patent Office
Office européen des brevets

(11) EP 1 535 976 B1

(12) **EUROPEAN PATENT SPECIFICATION**

(45) Date of publication and mention
of the grant of the patent:
**16.01.2008 Bulletin 2008/03**

(51) Int Cl.:
*C09D 183/04* *(2006.01)*     *C09D 183/14* *(2006.01)*
*H01L 21/312* *(2006.01)*

(21) Application number: **04028002.6**

(22) Date of filing: **25.11.2004**

(54) **Composition for film formation, method for preparing the composition, and method for forming insulating film**

Beschichtungszusammensetzung für die Filmherstellung, Verfahren zur Herstellung der Zusammensetzung und Verfahren zur Filmherstellung

Composition pour la fabrication de couches, procédé pour la fabrication de la composition et procédé pour la fabrication des couches

(84) Designated Contracting States:
**BE DE FR GB IT NL**

(30) Priority: **26.11.2003 JP 2003396034**

(43) Date of publication of application:
**01.06.2005 Bulletin 2005/22**

(73) Proprietor: **JSR Corporation**
**Tokyo (JP)**

(72) Inventors:
• **Akiyama, Masahiro,**
**JSR Corporation**
**Tokyo (JP)**

• **Sekiguchi, Manabu,**
**JSR Corporation**
**Tokyo (JP)**
• **Hattori, Seitaro,**
**JSR Corporation**
**Tokyo (JP)**
• **Kokubo, Terukazu,**
**JSR Corporation**
**Tokyo (JP)**

(74) Representative: **TBK-Patent**
**Bavariaring 4-6**
**80336 München (DE)**

(56) References cited:
**EP-A- 1 127 929      EP-A- 1 146 092**
**EP-A- 1 160 848**

**Description**

**FIELD OF THE INVENTION**

The present invention relates to a composition for film formation, a method for preparing the composition, and a method for forming a silica film using the composition. More particularly, the present invention relates to a composition for film formation having low dielectric constant, excellent adhesion to a silica film and excellent adhesion to an organic film, a method for preparing the composition, and a method for forming a silica film using the composition.

**BACKGROUND ART**

Silica ($SiO_2$) films formed by vacuum processes such as CVD method or organic films comprising an organic polymer as a main component are used as interlayer insulating films in semiconductor devices.

In recent years, an insulating coating film which comprises a tetraalkoxysilane hydrolyzate as the main component and is called an SOG (Spin On Glass) film has come to be used for the purpose of forming a further uniform film. Furthermore, as a result of the trend toward higher degree of integration in semiconductor devices, an interlayer insulating film called an organic SOG film has been developed which comprises a polyorganosiloxane as the main component and has a low dielectric constant.

On the other hand, with further progress in the degree of integration in semiconductor devices, better electrical insulation between conductors has come to be required and, hence, an interlayer insulating film material having further low dielectric constant has come to be desired.

One example of such an interlayer insulating film material can include a coating-type composition for formation of an insulating film having a low dielectric constant as disclosed in JP-A 2000-256621. This composition for coating formation is obtained by hydrolysis condensation of alkoxysilanes in the presence of a metal catalyst. Use of this composition can obtain a film having low dielectric constant, high elasticity and excellent CMP (Chemical Mechanical Polishing) resistance.

In recent production processes of semiconductor devices, CMP step is frequently employed to flatten a laminate film. On the other hand, formation of an organic film on a silica film is recently demanded to simplify a processing step. However, if treatment such as CMP is applied to a laminate film of a silica film and an organic film, there is the possibility that film peeling occurs between the silica film and the organic film due to poor adhesion therebetween.

**SUMMARY OF THE INVENTION**

Accordingly, one object of the present invention is to provide a composition for film formation that can form a silica film having low dielectric constant and excellent adhesion to an organic film due to large surface roughness thereof.

Another object of the present invention is to provide a method for preparing the composition of film formation.

Still another object of the present invention is to provide a method for forming a silica film using the composition.

The composition for film formation according to the present invention comprises:

(A) a product of hydrolysis and condensation obtained by hydrolyzing and condensing at least one silane compound selected from the group consisting of compounds represented by the following formulae (1) and (2) in the presence of an alkali catalyst:

$$R_a Si(OR^1)_{4-a} \qquad (1)$$

wherein R represents hydrogen atom, fluorine atom, or a monovalent organic group; $R^1$ represents a monovalent organic group; and a is an integer of 0 - 2;

$$R^2{}_b(R^3O)_{3-b}Si\text{-}(R^6)_d\text{-}Si(OR^4)_{3-c}\text{-}R^5{}_c \qquad (2)$$

wherein $R^2$ to $R^5$ may be the same or different and each represents a monovalent organic group; b and c may be the same or different and each is a number of 0 - 2; $R^6$ represents oxygen atom, phenylene group, or a group represented by $-(CH_2)_n-$, wherein n is an integer of 1 - 6; and d is 0 or 1; and
(B) an oxygen-containing organic solvent,

wherein the content of the product of hydrolysis and condensation (A) is less than 2% by weight based on the weight of the composition.

The alkali catalyst can be at least one selected from the group consisting of alkali metal hydroxides, ammonia, alkylamines and tetralakylamine salts.

The oxygen-containing organic solvent can have a boiling point of 100 - 200°C.

The oxygen-containing organic solvent can preferably be at least one selected from the group consisting of alkylene glycols, alkylene glycol monoalkyl ethers, alkylene glycol dialkyl ethers, alkylene glycol monoalkyl acetates, cyclic ethers and cyclcic ketones.

The method for preparing the composition for film formation according to the present invention comprises:

hydrolyzing and condensing at least one silane compound selected from the group consisting of compounds represented by the following formulae (1) and (2) in the presence of an alkali catalyst, water and an alcohol having 3 or less carbon atoms:

$$R_aSi(OR^1)_{4-a} \qquad (1)$$

wherein R represents hydrogen atom, fluorine atom, or a monovalent organic group; $R^1$ represents a monovalent organic group; and a is an integer of 0 - 2;

$$R^2_b(R^3O)_{3-b}Si-(R^6)_d-Si(OR^4)_{3-c}R^5c \qquad (2)$$

wherein $R^2$ to $R^5$ may be the same or different and each represents a monovalent organic group; b and c may be the same or different and each is a number of 0 - 2; $R^6$ represents oxygen atom, phenylene group, or a group represented by $-(CH_2)_n-$, wherein n is an integer of 1 - 6; and d is 0 or 1; and

adding an oxygen-containing organic solvent to the resulting product.

The method for forming an insulating film according to the present invention comprises:

a) applying the composition for film formation to a silica insulating film, and drying the resulting coating film, and

b) forming an organic insulating film on the film obtained in above step a).

## DETAILED DESCRIPTION OF THE INVENTION

The present invention is described in detail below.

The composition for film formation and its production method according to the present invention are specifically described below.

1. Composition for Film Formation

The composition for film formation according to the present invention comprises:

(A) a product of hydrolysis and condensation obtained by hydrolyzing and condensing at least one silane compound selected from the group consisting of a silane compound represented by the following formula (1) (hereinafter referred to as "compound 1") and a silane compound represented by the following formula (2) (hereinafter referred to as "compound 2") in the presence of an alkali catalyst:

$$R_aSi(OR^1)_{4-a} \qquad (1)$$

wherein R represents hydrogen atom, fluorine atom, or a monovalent organic group; $R^1$ represents a monovalent organic group; and a is an integer of 0 - 2;

$$R^2_b(R^3O)_{3-b}Si-(R^6)_d-Si(OR^4)_{3-c}R^5_c \qquad (2)$$

wherein $R^2$ to $R^5$ may be the same or different and each represents a monovalent organic group; b and c may be the same or different and each is a number of 0 - 2; $R^6$ represents oxygen atom, phenylene group, or a group represented by $-(CH_2)_n-$, wherein n is an integer of 1 - 6; and d is 0 or 1; and

(B) an oxygen-containing organic solvent,

wherein the content of the product of hydrolysis and condensation (A) is less than 2% by weight based on the weight of the composition.

The "hydrolyzate" used herein means that it is not necessary for all alkoxyl groups contained in at least one silane compound selected from the compounds (1) and (2) to be hydrolyzed, and includes a hydrolyzate in which only one of alkoxyl groups is hydrolyzed, a hydrolyzate in which at least two of alkoxyl groups are hydrolyzed, and a mixture of those.

The "condensate" used herein means a product in which silanol groups of hydrolyzates of the compounds 1 and 2 are condensed to form Si-O-Si bonds. However, in the present invention, all the silanol groups need not be condensed. Therefore, the term "condensate" means a concept including condensates in which slight proportion of silanol groups has been condensed, and a mixture of condensates which differ in the degree of condensation.

1.1 Component (A)

Compound 1:

Examples of the monovalent organic groups represented by R and $R^1$ in formula (1) include alkyl, aryl, allyl, and glycidyl groups. In formula (1), R is preferably a monovalent organic group, more preferably an alkyl or phenyl group.

The alkyl group preferably has 1 to 5 carbon atoms, and examples thereof include methyl, ethyl, propyl, and butyl. These alkyl groups may be linear or branched, and may be ones in which one or more of the hydrogen atoms have been replaced with, for example, fluorine atoms.

In formula (1), examples of the aryl group include phenyl, naphthyl, methylphenyl, ethylphenyl, chlorophenyl, bromophenyl, and fluorophenyl.

Examples of the compounds represented by formula (1) include:

trimethoxysilane, triethoxysilane, tri-n-propoxysilane, triisopropoxysilane, tri-n-butoxysilane, tri-sec-butoxysilane, tri-tert-butoxysilane, triphenoxysilane, fluorotrimethoxysilane, fluorotriethoxysilane, fluorotri-n-propoxysilane, fluorotriisopropoxysilane, fluorotri-n-butoxysilane, fluorotri-sec-butoxysilane, fluorotri-tert-butoxysilane, and fluorotriphenoxysilane;

methyltrimethoxysilane, methyltriethoxysilane, methyltri-n-propoxysilane, methyltriisopropoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltriisopropoxysilane, ethyltri-n-butoxysilane, ethyltri-sec-butoxysilane, ethyltri-tert-butoxysilane, ethyltriphenoxysilane, vinyltrimethoxysilane, vinyltriethoxysilane, vinyltri-n-propoxysilane, vinyltriisopropoxysilane, vinyltri-n-butoxysilane, vinyltri-sec-butoxysilane, vinyltri-tert-butoxysilane, vinyltriphenoxysilane, n-propyltrimethoxysilane, n-propyltriethoxysilane, n-propyltri-n-propoxysilane, n-propyltriisopropoxysilane, n-propyltri-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n-butyltriisopropoxysilane, n-butyltri-n-butoxysilane, n-butyltri-sec-butoxysilane, n-butyltri-tert-butoxysilane, n-butyltriphenoxysilane, sec-butyltrimethoxysilane, sec-butyltriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, phenyltrimethoxysilane, phenyltriethoxysilane, phenyltri-n-propoxysilane, phenyltriisopropoxysilane, phenyltri-n-butoxysilane, phenyltri-sec-butoxysilane, phenyltri-tert-butoxysilane, phenyltriphenoxysilane, vinyltrimethoxysilane, vinyltriethoxysilane, γ-aminopropyltrimethoxysilane, γ-aminopropyltriethoxysilane, γ-glycidoxypropyltrimethoxysilane, γ-glycidoxypropyltriethoxysilane, γ-trifluoropropyltrimethoxysilane and γ-trifluoropropyltriethoxysilane; and

dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldiethoxysilane, di-n-propyldi-n-propoxysilane, di-n-propyldiisopropoxysilane, di-n-propyldi-n-butoxysilane, di-n-propyldi-sec-butoxysilane, di-n-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n-butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, and divinyltrimethoxysilane.

Preferred examples of the compounds (1) include tetramethoxysilane, tetraethoxysilane, tetra-n-propoxysilane, tetra-iso-propoxysilane, tetra-n-buyoxysilane, tetra-sec-butoxysilane, tetra-tert-butoxysilane, tetraphenoxysilane, methyltrimethoxysilane, methyltriethoxysilane, methyltri-n-propoxysilane, methyltriisopropoxysilane, ethyltrimethoxysilane, ethyltriethoxysilane, vinyltrimethoxysilane, vinyltriethoxysilane, phenyltrimethoxysilane, phenyltriethoxysilane, dimethyldimethoxysilane, dimethyldiethoxysilane, diethyldimethoxysilane, diethyldiethoxysilane, diphenyldimethoxysilane, and diphenyldiethoxysilane.

Those compounds may be used alone or in combination of two or more thereof.

Compound 2:

Examples of the monovalent organic groups represented by $R^2$ to $R^5$ in formula (2) include the same monovalent organic groups as those enumerated above with regard to formula (1).

Examples of the compounds represented by formula (2) wherein $R^6$ is an oxygen atom include hexamethoxydisiloxane, hexaethoxydisiloxane, hexaphenoxydisiloxane, 1,1,1,3,3-pentamethoxy-3-methyldisiloxane, 1,1,1,3,3-pentaethoxy-3-methyldisiloxane, 1,1,1,3,3-pentaphenoxy-3-methyldisiloxane, 1,1,1,3,3-pentamethoxy-3-ethyldisiloxane, 1,1,1,3,3-pentaethoxy-3-ethyldisiloxane, 1,1,1,3,3-pentaphenoxy-3-ethyldisiloxane, 1,1,1,3,3-pentamethoxy-3-phenyldisiloxane, 1,1,1,3,3-pentaethoxy-3-phenyldisiloxane, 1,1,1,3,3-pentaphenoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetraphenoxy-1,3-dimethyldisiloxane, 1,1,3,3-tetramethoxy-1,3-diethyldisiloxane, 1,1,3,3-tetraethoxy-1,3-diethyldisiloxane, 1,1,3,3-tetraphenoxy-1,3-diethyldisiloxane, 1,1,3,3-tetramethoxy-1,3-diphenyldisiloxane, 1,1,3,3-tetraethoxy-1,3-diphenyldisiloxane, 1,1,3,3-tetraphenoxy-1,3-diphenyldisiloxane, 1,1,3-trimethoxy-1,3,3-trimethyldisiloxane, 1,1,3-triethoxy-1,3,3-trimethyldisiloxane, 1,1,3-triphenoxy-1,3,3-trimethyldisiloxane, 1,1,3-trimethoxy-1,3,3-triethyldisiloxane, 1,1,3-triethoxy-1,3,3-triethyldisiloxane, 1,1,3-triphenoxy-1,3,3-triethyldisiloxane, 1,1,3-trimethoxy-1,3,3-triphenyldisiloxane, 1,1,3-triethoxy-1,3,3-triphenyldisiloxane, 1,1,3-triphenoxy-1,3,3-triphenyldisiloxane, 1,3-dimethoxy-1,1,3,3-tetramethyldisiloxane, 1,3-diethoxy-1,1,3,3-tetramethyldisiloxane, 1,3-diphenoxy-1,1,3,3-tetramethyldisiloxane, 1,3-dimethoxy-1,1,3,3-tetraethyldisiloxane, 1,3-diethoxy-1,1,3,3-tetraethyldisiloxane, 1,3-diphenoxy-1,1,3,3-tetraethyldisiloxane, 1,3-dimethoxy-1,1,3,3-tetraphenyldisiloxane, 1,3-diethoxy-1,1,3,3-tetraphenyldisiloxane, and 1,3-diphenoxy-1,1,3,3-tetraphenyldisiloxane.

Preferred examples of those compounds are hexamethoxydisiloxane, hexaethoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane, and 1,3-diethoxy-1,1,3,3-tetraphenyldisiloxane.

Examples of the compounds represented by formula (2) wherein d is 0 include hexamethoxydisilane, hexaethoxydisilane, hexaphenoxydisilane, 1,1,1,2,2-pentamethoxy-2-methyldisilane, 1,1,1,2,2-pentaethoxy-2-methyldisilane, 1,1,1,2,2-pentaphenoxy-2-methyldisilane, 1,1,1,2,2-pentamethoxy-2-ethyldisilane, 1,1,1,2,2-pentaethoxy-2-ethyldisilane, 1,1,1,2,2-pentaphenoxy-2-ethyldisilane, 1,1,1,2,2-pentamethoxy-2-phenyldisilane, 1,1,1,2,2-pentaethoxy-2-phenyldisilane, 1,1,1,2,2-pentaphenoxy-2-phenyldisilane, 1,1,2,2-tetramethoxy-1,2-dimethyldisilane, 1,1,2,2-tetraethoxy-1,2-dimethyldisilane, 1,1,2,2-tetraphenoxy-1,2-dimethyldisilane, 1,1,2,2-tetramethoxy-1,2-diethyldisilane, 1,1,2,2-tetraethoxy-1,2-diethyldisilane, 1,1,2,2-tetraphenoxy-1,2-diethyldisilane, 1,1,2,2-tetramethoxy-1,2-diphenyldisilane, 1,1,2,2-tetraethoxy-1,2-diphenyldisilane, 1,1,2,2-tetraphenoxy-1,2-diphenyldisilane, 1,1,2-trimethoxy-1,2,2-trimethyldisilane, 1,1,2-triethoxy-1,2,2-trimethyldisilane, 1,1,2-triphenoxy-1,2,2-trimethyldisilane, 1,1,2-trimethoxy-1,2,2-triethyldisilane, 1,1,2-triethoxy-1,2,2-triethyldisilane, 1,1,2-triphenoxy-1,2,2-triethyldisilane, 1,1,2-trimethoxy-1,2,2-triphenyldisilane, 1,1,2-triethoxy-1,2,2-triphenyldisilane, 1,1,2-triphenoxy-1,2,2-triphenyldisilane, 1,2-dimethoxy-1,1,2,2-tetramethyldisilane, 1,2-diethoxy-1,1,2,2-tetramethyldisilane, 1,2-diphenoxy-1,1,2,2-tetramethyldisilane, 1,2-dimethoxy-1,1,2,2-tetraethyldisilane, 1,2-diethoxy-1,1,2,2-tetraethyldisilane, 1,2-diphenoxy-1,1,2,2-tetraethyldisilane, 1,2-dimethoxy-1,1,2,2-tetraphenyldisilane, 1,2-diethoxy-1,1,2,2-tetraphenyldisilane, and 1,2-diphenoxy-1,1,2,2-tetraphenyldisilane.

Preferred examples of those compounds are hexamethoxydisilane, hexaethoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, and 1,2-diethoxy-1,1,2,2-tetraphenyldisilane.

Examples of the compounds represented by formula (2) wherein $R^6$ is a group represented by $-(CH_2)_n-$ include bis(trimethoxysilyl)methane, bis(triethoxysilyl)methane, bis(tri-n-propoxysilyl)methane, bis(triisopropoxysilyl)methane, bis(tri-n-butoxysilyl)methane, bis(tri-sec-butoxysilyl)methane, bis(tri-t-butoxysilyl)methane, 1,2-bis(trimethoxysilyl)ethane, 1,2-bis(triethoxysilyl)ethane, 1,2-bis(tri-n-propoxysilyl)ethane, 1,2-bis(triisopropoxysilyl)ethane, 1,2-bis(tri-n-butoxysilyl)ethane, 1,2-bis(tri-sec-butoxysilyl)ethane, 1,2-bis(tri-t-butoxysilyl)ethane, 1-(dimethoxymethylsilyl)-1-(trimethoxysilyl)methane, 1-(diethoxymethylsilyl)-1-(triethoxysilyl)methane, 1-(di-n-propoxymethylsilyl)-1-(tri-n-propoxysilyl) methane, 1-(diisopropoxymethylsilyl)-1-(triisopropoxysilyl)methane, 1-(di-n-butoxymethylsilyl)-1-(tri-n-butoxysilyl)methane, 1-(di-sec-butoxymethylsilyl)-1-(tri-sec-butoxysilyl)methane, 1-(di-t-butoxymethylsilyl)-1-(tri-t-butoxysilyl)methane, 1-(dimethoxymethylsilyl)-2-(trimethoxysilyl)ethane, 1-(diethoxymethylsilyl)-2-(triethoxysilyl)ethane, 1-(di-n-propoxymethylsilyl)-2-(tri-n-propoxysilyl)ethane, 1-(diisopropoxymethylsilyl)-2-(triisopropoxysilyl)ethane, 1-(di-n-butoxymethylsilyl)-2-(tri-n-butoxysilyl)ethane, 1-(di-sec-butoxymethylsilyl)-2-(tri-sec-butoxysilyl)ethane, 1-(di-t-butoxymethylsilyl)-2-(tri-t-butoxysilyl)ethane, bis(dimethoxymethylsilyl)methane, bis(diethoxymethylsilyl)methane, bis(di-n-propoxymethylsilyl)methane, bis(diisopropoxymethylsilyl)methane, bis(di-n-butoxymethylsilyl)methane, bis(di-sec-butoxymethylsilyl)methane, bis(di-t-butoxymethylsilyl)methane, 1,2-bis(dimethoxymethylsilyl)ethane, 1,2-bis(diethoxymethylsilyl)ethane, 1,2-bis(di-n-propoxymethylsilyl)ethane, 1,2-bis(diisopropoxymethylsilyl)ethane, 1,2-bis(di-n-butoxymethylsilyl)ethane, 1,2-bis(di-sec-butoxymethylsilyl)ethane, and 1,2-bis(di-t-butoxymethylsilyl)ethane.

Preferred examples of those compounds are bis(trimethoxysilyl)methane, bis(triethoxysilyl)methane, 1,2-bis(trimethoxysilyl)ethane, 1,2-bis(triethoxysilyl)ethane, 1-(dimethoxymethylsilyl)-1-(trimethoxysilyl)methane, 1-(diethoxymethylsilyl)-1-(triethoxysilyl)methane, 1-(dimethoxymethylsilyl)-2-(trimethoxysilyl)ethane, 1-(diethoxymethylsilyl)-2-(triethoxysilyl)ethane, bis(dimethoxymethylsilyl)methane, bis(diethoxymethylsilyl)methane, 1,2-bis(dimethoxymethylsilyl)ethane, and 1,2-bis(diethoxymethylsilyl)ethane.

Examples of the compounds represented by formula (2) wherein $R^6$ is a group represented by phenylene group include 1,2-bis(trimethoxysilyl)benzene, 1,2-bis(triethoxysilyl)benzene, 1,2-bis(tri-n-propoxysilyl)benzene, 1,2-bis(triisopropoxysilyl)benzene, 1,2-bis(tri-n-butoxysilyl)benzene, 1,2-bis(tri-sec-butoxysilyl)benzene, 1,2-bis(tri-t-butoxysilyl) benzene, 1,3-bis(trimethoxysilyl)benzene, 1,3-bis(triethoxysilyl)benzene, 1,3-bis(tri-n-propoxysilyl)benzene, 1,3-bis(triisopropoxysilyl)benzene, 1,3-bis(tri-n-butoxysilyl)benzene,1,3-bis(tri-sec- butoxysilyl)benzene, 1,3-bis(tri-t-butoxysilyl) benzene, 1,4-bis(trimethoxysilyl)benzene, 1,4-bis(triethoxysilyl)benzene, 1,4-bis(tri-n-propoxysilyl)benzene, 1,4-bis(triisopropoxysilyl)benzene, 1,4-bis(tri-n-butoxysilyl)benzene, 1,4-bis(tri-sec-butoxysilyl)benzene, and 1,4-bis(tri-t-butoxysilyl)benzene.

Preferred examples of those compounds include 1,2-bis(trimethoxysilyl)benzene, 1,2-bis(triethoxysilyl)benzene, 1,3-bis(trimethoxysilyl)benzene, 1,3-bis(triethoxysilyl)benzene, 1,4-bis(trimethoxysilyl)benzene, and 1,4-bis(triethoxysilyl)benzene.

In the present invention, the compounds (1) and (2) described above may be used alone or in combination of two or more thereof as the silane compound.

Alkali catalyst:

In the present invention, hydrolyzing and condensing the silane compound selected from the above-described compounds (1) and (2) can be conducted in the presence of an alkali catalyst.

Examples of the alkali catalyst that can be used include at least one selected from the group consisting of alkali metal hydroxides, ammonia, alkyl amines and tetraalkyl amine salts.

Examples of the alkali metal hydroxides include sodium hydroxide, potassium hydroxide, barium hydroxide, and calcium hydroxide.

Examples of the alkyl amines include methanolamine, ethanolamine, propanolamine, butanolamine, N-methyl methanolamine, N-ethyl methanolamine, N-propyl methanolamine, N-butyl methanolamine, N-methyl ethanolamine, N-ethyl ethanolamine, N-propyl ethanolamine, N-butyl ethanolamine, N-methyl propanolamine, N-ethyl propanolamine, N-propyl propanolamine, N-butyl propanolamine, N-methyl butanolamine, N-ethyl butanolamine, N-propyl butanolamine, N-butyl butanolamine, N,N-dimethyl methanolamine, N,N-diethyl methanolamine, N,N-dipropyl methanolamine, N,N-dibutyl methanolamine, N,N-dimethyl ethanolamine, N,N-diethyl ethanolamine, N,N-dipropyl ethanolamine, N,N-dibutyl ethanolamine, N,N-dimethyl propanolamine, N,N-diethyl popanolamine, N,N-dipropyl propanolamine, N,N-dibutyl propanolamine, N,N-dibutyl butanolamine, N,N-diethyl butanolamine, N,N-dipropyl butanolamine, N,N-dibutyl butanolamine, N-methyl dimethanolamine, N-ethyl dimethanolamine, N-propyl dimethanolamine, N-butyl dimethanolamine, N-methyl diethanolamine, N-ethyl diethanolamine, N-propyl diethanolamine, N-butyl diethanolamine, N-methyl dipropanolamine, N-ethyl dipropanolamine, N-propyl dipropanolamine, N-butyl dipropanolamine, N-methyl dibutanolamine, N-ethyl dibutanolamine, N-propyl dibutanolamine, N-butyl dibutanolamine, N-(aminomethyl) methanolamine, N-(aminomethyl) ethanolamine, N-(aminoethyl) propanolamine, N-(aminomethyl) butanolamine, N-(aminoethyl) methanolamine, N-(aminoethyl) ethanolamine, N-(aminoethyl) propanolmine, N-(aminoethyl) butanolamine, N-(aminopropyl) methanolamine, N-(aminopropyl) ethanolamine, N-(aminopropyl) propanolamine, N-(aminopropyl) butanolamine, N-(aminobutyl) methanolamine, N-(aminobutyl) ethanolamine, N-(aminobutyl) propanolamine, N-(aminobutyl) butanolamine, methoxymethyl amine, ethoxymethyl amine, methoxypropyl amine, methoxybutylamine, ethoxymethyl amine, ethoxyethyl amine, ethoxypropyl amine, ethoxybutylamine, propoxymethyl amine, propoxyethyl amine, propoxypropyl amine, propoxybutyl amine, butoxymethyl amine, butoxyethyl amine, butoxypropyl amine, butoxybutyl amine, methylamine, ethylamine, propylamine, butylamine, N,N-dimethylamine, N,N-diethylamine, N,N-dipropylamine, N,N-dibutylamine, trimetylamine, triethylamine, tripropylamine, tributylamine, tetramethylethylene amine, tetraethylethylene amine, tetrapropylethylene amine, tetrabutylethylene amine, methyl aminomethylamine, metyl aminoethylamine, methyl aminopropylamine, methyl aminobutylamine, ethyl aminoethylamine, ethyl aminoethylamine, ethyl amnopropylamine, ethyl aminobutylamine, propyl aminomethylamine, propyl aminoethylamine, propyl aminoproppylamine, propyl aminobutylamine, butyl aminomethylamine, butyl aminoethylamine, butyl aminopropylamine, butyl aminobutylamine, pyridine, pyrrole, piperazine, pyrrolidine, piperidine, picoline, morpholine, methylmorpholine, diazabicyclooctane, diazabicyclononane, and diazabicycloundecene.

Examples of the tetraalkylamine salts include tetramethylammonium hydroxide, tetraethylammonium hydroxide, tetrapropylammonium hydroxide, tetrabutylammonium hydroxide, and benzyltrimethylammonium hydroxide.

The alkali catalyst can be used in an amount of generally 0.00001 - 0.5 mol, preferably 0.00001 - 0.3 mol, per mole of the sum of $R^1O$ groups, $R^3O$ groups and $R^4O$ groups in the compounds (1) and (2). Where the component (A) is a condensate of the compounds (1) and (2), it has a weight average molecular weight, in terms of polystyrene conversion, of generally about 500 - 1,000,000, preferably 700 - 500,000, more preferably 1,000 - 300,000.

1.2 Component (B)

In the composition for film formation according to the present invention, a solvent having a boiling point of preferably 100 - 200°C, more preferably 100 - 190°C, is used as the oxygen-containing organic solvent (B). Where the boiling point is fallen outside the above range, coating properties of the composition for film formation deteriorate, and a homogeneous film may not be obtained.

Any compound can be used as the oxygen-containing organic solvent (B) so long as it is a compound containing at least one oxygen atom in the skeleton thereof. Preferred examples of the oxygen-containing organic solvent (B) that can be used include alkylene glycol, alkylene glycol monoalkylether, alkylene glycol dialkylether, alkylene glycol monoalkylacetate, cyclic ether and cyclic ketone.

Examples of alkylene glycol include ethylene glycol, 1,2-propylelene glycol, 1,3-propylene glycol, 1,3-butylene glycol, 1,4-butylene glycol, pentane diol-2,4, 2-methylpentane diol-2,4, hexane diol-2,5, heptane diol-2,4, 2-ethylhexane diol-1,3, diethylene glycol, dipropylene glycol, triethylene glycol, and tripropylene glycol.

Examples of alkylene glycol monoalkyl ether include ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycolmonoethyl ether, propylene glycol monopropyl ether, propylene glycol monobutyl ether, dipropylene glycol monomethyl ether, dipropylene glycol monoethyl ether, and dipropylene glycol monopropyl ether.

Examples of alkylene glycol dialkyl ether include propylene glycol dimethyl ether, propylene glycol diethyl ether, propylene glycol dipropyl ether, propylene glycol dibutyl ether, dipropylene glycol dimethyl ether, dipropylene glycol diethyl ether, dipropylene glycol dipropyl ether, and dipropylene glycol dibutyl ether.

Examples of alkylene glycol monoalkyl acetate include ethylene glycol monomethyl acetate, ethylene glycol monoethyl acetate, ethylene glycol monopropyl acetate, ethylene glycol monombutyl acetate, propylene glycol monomethyl acetate, propylene glycol monoethyl acetate, propylene glycol monopropyl acetate, propylene glycol monombutyl acetate, butylene glycol monomethyl acetate, butylene glycol monoethyl acetate, butylene glycol monopropyl acetate, butylene glycol monobutyl acetate, diethylene glycol monomethyl acetate, diethylene glycol monoethyl acetate, diethylene glycol monopropyl acetate, diethylene glycol monobutyl acetate, dipropylene glycol monomethyl acetate, dipropylene glycol monoethyl acetate, dipropylene glycol monopropyl acetate, and dipropylene glycol monobutyl acetate.

Examples of cyclic ether include tetrahydrofuran, and 2-methyl tetrahydrofuran.

Examples of cyclic ketone include cyclohexanone, methyl cyclohexanone, phorone, isophorone, and γ-butyrolactone.

Those organic solvent can be used alone or as mixtures of two or more thereof.

In the present invention, cyclic ether and/or cyclic ketone are particularly preferably used.

In the composition for film formation of the present invention, it is preferable to adjust the pH of the final composition to 7 or lower.

Examples of methods for pH adjustment include:

(a) a method of adding a pH regulator;
(b) a method of distilling off the alkali from the composition at atmospheric pressure or reduced pressure;
(c) a method of bubbling a gas such as nitrogen or argon into the composition to thereby remove the alkali catalyst from the composition;

EP 1 535 976 B1

(d) a method of removing the alkali catalyst from the composition with an ion-exchange resin; and

(e) a method of removing the alkali catalyst from the system by extraction or washing.

Those methods may be used alone or in combination of two or more thereof.

Examples of the pH regulator include inorganic acids and organic acids.

Examples of the inorganic acids include hydrochloric acid, nitric acid, sulfuric acid, hydrofluoric acid, phosphoric acid, boric acid, and oxalic acid.

Examples of the organic acids include acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, shikimic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acids, phthalic acid, fumaric acid, citric acid, tartaric acid, succinic acid, itaconic acid, mesaconic acid, citraconic acid, malic acid, a glutaric acid hydrolyzate, a maleic anhydride hydrolyzate, and a phthalic anhydride hydrolyzate.

Those compounds may be used alone or in combination of two or more thereof.

Such a pH regulator is used to adjust the pH of the composition to 7 or lower, preferably 1 to 6. Adjusting the pH of the composition with the pH regulator to a value within above range produces the effect that the composition obtained has improved storage stability.

The pH regulator is used in an amount suitably selected such that the pH of the composition becomes a value within that range.

1.3 Other Additives

Ingredients such as colloidal silica, colloidal alumina, surfactants, or silane coupling agents may be added to the composition for film formation obtained in the present invention.

The colloidal silica is a dispersion comprising, for example, any of the aforementioned hydrophilic organic solvents and high-purity silicic acid anhydride dispersed therein. It has an average particle diameter of generally from 5 to 30 nm, preferably from 10 to 20 nm, and a solid concentration of generally about from 10 to 40% by weight. Examples of the colloidal silica include the methanol silica sol and isopropanol silica sol manufactured by Nissan Chemical Industries, Ltd. and Oscal, manufactured by Catalysts & Chemicals Industries Co., Ltd.

Examples of the colloidal alumina include Alumina Sol 520, 100, and 200, manufactured by Nissan Chemical Industries, Ltd., and Alumina Clear Sol and Alumina Sol 10 and 132, manufactured by Kawaken Fine Chemicals Co., Ltd.

Examples of the surfactants include nonionic surfactants, anionic surfactants, cationic surfactants, and amphoteric surfactants, and further include fluorochemical surfactants, silicone surfactants, poly(alkylene oxide) surfactants, and poly(meth)acrylate surfactants. Preferred examples of those are fluorochemical surfactants and silicone surfactants.

The fluorochemical surfactants are ones comprising a compound having a fluoroalkyl or fluoroalkylene group in at least one position selected from the ends, main chain, and side chains. Examples thereof include 1,1,2,2-tetrafluorooctyl 1,1,2,2-tetrafluoropropyl ether, 1,1,2,2-tetrafluorooctyl hexyl ether, octaethylene glycol di(1,1,2,2-tetrafluorobutyl) ether, hexaethylene glycol 1,1,2,2,3,3-hexafluoropentyl ether, octapropylene glycol di(1,1,2,2-tetrafluorobutyl) ether, hexapropylene glycol di(1,1,2,2,3,3-hexafluoropentyl) ether, sodium perfluorododecylsulfonate, 1,1,2,2,8,8,9,9,10,10-decafluorododecane, 1,1,2,2,3,3-hexafluorodecane, N-[3-perfluorooctanesulfonamido)propyl]-N, N'-dimethyl-N-carboxymethylene ammonium betaine, perfluoroalkylsulfonamidopropyltrimethyl ammonium salts, perfluoroalkyl-N-ethylsulfonyl glycine salts, bis(N-perfluorooctylsulfonyl-N-ethylaminoethyl) phosphate, and monoperfluoroalkylethyl phosphates.

Commercially available products of such fluorochemical surfactants include products available under the trade names of Megafac F142D, F172, F173, and F183 (manufactured by Dainippon Ink & Chemicals, Inc.); F-Top EF301, EF303, and EF352 (manufactured by New Akita Chemical Company); Fluorad FC-430 and FC-431 (manufactured by Sumitomo 3M Ltd.); Asahi Guard AG710 and Surflon S-382, SC-101, SC-102, SC-103, SC-104, SC-105, and SC-106 (manufactured by Asahi Glass Co., Ltd.); BM-1000 and BM-1100 (manufactured by Yusho K.K.); and NBX-15 (manufactured by NEOS Co., Ltd.). Especially preferred examples of those are Megafac F172, BM-1000, BM-1100, and NBX-15.

Examples of the silicone surfactants include SH7PA, SH21PA, SH30PA, and ST94PA (all manufactured by Dow Coming Toray Silicone Co., Ltd.). Especially preferred examples of those are SH28PA and SH30PA.

The amount of such a surfactant to be used is usually from 0.0001 to 10 parts by weight per 100 parts by weight of component (A) (in terms of the product of complete hydrolysis and condensation).

Those surfactants may be used alone or in combination of two or more thereof.

Examples of the silane coupling agents include 3-glycidyloxypropyltrimethoxysilane, 3-aminoglycidyloxypropyltriethoxysilane, 3-methacryloxypropyltrimethoxysilane, 3-glycidyloxypropylmethyldimethoxysilane, 1-methacryloxypropylmethyldimethoxysilane, 3-aminopropyltrimethoxysilane, 3 -aminopropyltriethoxysilane, 2-aminopropyltrimethoxysilane, 2-aminopropyltriethoxysilane, N-(2-aminoethyl)-3-aminopropyltrimethoxysilane, N-(2-aminoethyl)-3-aminopropylmethyldimethoxysilane, 3-ureidopropyltrimethoxysilane, 3-ureidopropyltriethoxysilane, N-ethoxycarbonyl-3-aminopropyltrimethoxysilane, N-ethoxycarbonyl-3-aminopropyltriethoxysilane, N-triethoxysilylpropyltriethylenetriamine, N-trimethoxysilylpropyltriethylenetriamine, 10-trimethoxysilyl-1,4,7-triazadecane, 10-triethoxysilyl-1,4,7-triazadecane, 9-trimethoxysilyl-3,6-diazanonyl acetate, 9-triethoxysilyl-3,6-diazanonyl acetate, N-benzyl-3-aminopropyltrimethoxysilane, N-benzyl-3-aminopropyltriethoxysilane, N-phenyl-3-aminopropyltrimethoxysilane, N-phenyl-3-aminopropyltriethoxysilane, N-bis(oxyethylene)-3-aminopropyltrimethoxysilane, and N-bis(oxyethylene)-3-aminopropyltriethoxysilane.

Those silane coupling agents may be used alone or in combination of two or more thereof.

The total solid content concentration in the composition for film formation according to the present invention is preferably 0.1-less than 2% by weight based on the weight of the composition. The concentration is appropriately adjusted according to the purpose of use. Due to that the total solid content concentration in the composition for film formation according to the present invention is 0.1-less than 2% by weight, the film thickness of the coating film is fallen within an appropriate range, thereby the film has further excellent storage stability. If necessary, the adjustment of the total solid content concentration may be conducted by concentration or dilution with a solvent exemplified as the oxygen-containing organic solvent, or other solvent.

2. Methods for Preparing the Composition for Film Formation

In the method for preparing the composition for film formation according to the present invention, at least one silane compound selected from the group consisting of the compound 1 and the compound 2 is subjected to hydrolysis and condensation in the presence of the alkali catalyst, water and organic solvent.

The organic solvent used in the preparation method is alcohols having 3 or less carbon atoms. Examples of the alcohol having 3 or less carbon atoms include methanol, ethanol, n-propanol, and isopropanol.

Use of such an alcohol as the organic solvent has the advantage that hydrolysis and condensation reactions are conducted in a stable manner without precipitation or gelation of a polymer.

In the method for preparing the composition for film formation according to the present invention, the method of hydrolyzing and condensing a silane compound selected from the group consisting of the compound 1 and the compound 2 is not particularly limited, and includes, for example, the following embodiments 1) to 4).

1) A method in which a silane compound selected from the compound 1 or 2 is added to a mixture comprising an organic solvent, an alkali catalyst and water to conduct hydrolysis and condensation reactions.

2) A method in which a silane compound selected from the compound 1 or 2 is continuously or intermittently added to a mixture comprising an organic solvent, an alkali catalyst and water to conduct hydrolysis and condensation reactions.

3) A method in which an organic solvent and water are en bloc, continuously or intermittently added to a mixture comprising an organic solvent, an alkali catalyst and a silane compound selected from the compound 1 or 2 to conduct hydrolysis and condensation reactions.

4) A method in which an alkali catalyst is added to a mixture comprising an organic solvent, a silane compound selected from the compound 1 or 2, and water to conduct hydrolysis and condensation reactions.

In the reaction system, the concentration of the silane compound selected from the compound 1 or 2 is preferably adjusted to 0.1-30% by weight. If the concentration of each component in the reaction system is outside the above range, hydrolysis and condensation reaction may not proceed sufficiently or gelation may occur during reaction, which is not preferable.

After completion of the hydrolysis and condensation reactions by the above step, the oxygen-containing organic solvent as component (B) is added to a product of hydrolysis and condensation. In such a case, the content of the product of hydrolysis and condensation as component (A) is adjusted so as to be preferably 0.1-less than 2% by weight, more preferably 0.3-less than 2% by weight. By limiting the content of component (A) to the above specified range, the coating film has a film thickness in a suitable range, and also has further excellent storage stability.

The composition for film formation prepared by the above step can increase a surface roughness when forming a coating film. The surface roughness is preferably 10 nm or more. For this reason, when laminated with an organic film, adhesion can be improved by an anchor effect that the organic film enters into a coating film obtained using the composition for film formation of the present invention.

The oxygen-containing organic solvent of component (B) has an appropriate solubility to a product of hydrolysis and condensation of the present invention, and an appropriate boiling point, so that an appropriate evaporation rate is obtained in forming a coating film. As a result, a composition for film formation having excellent storage stability and providing good coating film can be obtained.

The method for preparing a composition for film formation according to the present invention is explained above by reference to a method in which a silane compound selected from compounds 1 and 2 is hydrolyzed and condensed, and the oxygen-containing organic solvent of component (B) is then added to the resulting product, but other method can be employed, which uses a mixed solvent of an alcohol having 3 or less carbon atoms and the oxygen-containing organic solvent of component (B) as an organic solvent in hydrolyzing and condensing a silane compound selected from compounds 1 and 2.

A silica film obtained from the composition for film formation of the present invention has excellent dielectric characteristics and storage stability, and is therefore preferably used as an interlayer insulating film material. Further, because such a silica film has large surface roughness, when the silica film is laminated with an organic film, a laminate having improved adhesion therebetween can be obtained. Even when the silica film is laminated with other silica film having a similar composition, the silica film can be well adhered to the other silica film. For this reason, when the silica film obtained from the composition of the present invention is interposed between an organic film and other silica film that does not obtain good adhesion when directly laminated with an organic film, an insulating laminate having improved adhesion can be obtained.

For example, adhesion between the conventional silica insulating film and an organic insulating film can be improved by 1) applying the composition for film formation of the present invention to a silica insulating film, and 2) then further forming an organic insulating film of the film obtained in 1).

The conventional silica insulating film can include a film obtained by spin coating a solution such as methyl polysiloxane or hydrogen polysiloxane, and a film obtained by CVD method.

The organic insulating film can include polyether, polybenzimidazole, polyimide, and the like, having a dielectric constant of less than 3.5.

The silica film of the present invention has the above-described advanatages, and is therefore suitable for use in interlayer insulating films for semiconductor devices such as LSIs, system LSIs, DRAMs, SDRAMs, RDRAMs, and D-RDRAMs, protective films such as surface coat films for semiconductor devices, interlayers for use in semiconductor production processes employing a multilayered resist, interlayer insulating films for multilayered printed circuit boards, and protective or insulating films for liquid crystal display devices.

The present invention is described in more detail by reference to the following Examples, but it should be understood that the invention is not construed as being limited thereto. Unless otherwise indicated, all parts, percents and the like are by weight.

In the Examples, to confirm the film formation compositions 1-3 of the present invention and adhesion of those compositions, film formation compositions for forming other silica films and film formation compositions for forming organic films were formed.

Various evaluations were made as follows.

Storage Stability

A film formation composition stored at 40°C for 30 days was applied to a substrate by spin coating. The coated substrate was dried at 90°C for 3 minutes on a hot plate and at 200°C for 3 minutes in nitrogen atmosphere. The coating film formed on the substrate was cured in a vertical furnace at 420°C under reduced pressure of 50 mTorr. Film thickness of the coating film thus obtained was measured at 50 points on the surface thereof using an ellipsometer (Spectra Laser 200, manufactured by Rudolph Technologies). Using the film thickness thus measured, storage stability of the coating film was evaluated by the increase in film thickness obtained by the following equation.

$$\text{Increase in film thickness (\%)} = \frac{\text{(Film thickness after storage)-(Film thickness before storage)}}{\text{Film thickness before storage}} \times 100$$

Good: Increase in film thickness is 4% or less
Poor: Increase in film thickness is more than 4%

Measurement of Dielectric Constant

A film formation composition was applied to an 8-inch silicon wafer by spin coating. The coated wafer was dried at 90°C for 3 minutes on a hot plate and then at 200°C for 3 minutes in nitrogen atmosphere. The coating film formed on the wafer was cured in a vertical furnace at 420°C under reduced pressure of 50 mTorr. An aluminum electrode pattern was formed on this film by vapor deposition. Thus, a sample for dielectric constant measurement was produced. This sample was examined at a frequency of 100 kHz with electrodes HP16451B and precision LCR meter HP4284A, both manufactured by Yokogawa-Hewlett-Packard, Ltd., by the CV method to determine the dielectric constant of the coating film.

Surface Roughness of Coating Film

A film formation composition was applied to an 8-inch silicon wafer by spin coating. The coated wafer was dried at 90°C for 3 minutes on a hot plate and then at 200°C for 3 minutes in nitrogen atmosphere. The coating film formed on the wafer was cured in a vertical furnace at 420°C under reduced pressure of 50 mTorr. Surface roughness (Rmax) of the coating film obtained was measured using Nanoscope IIIa, manufactured by Digital Instrument Co., with a tapping mode.

Adhesion

A film formation composition for forming other silica film described hereinafter was applied to an 8-inch silicon wafer by spin coating. The coated wafer was dried at 90°C for 3 minutes on a hot plate and then at 200°C for 3 minutes in nitrogen atmosphere. The coating film formed on the wafer was cured in a vertical furnace at 420°C under reduced pressure of 50 mTorr.

A film formation composition according to each of the Examples and the Comparative Examples described hereinafter was applied to the cured film obtained above by spin coating. The coating on the cured film was dried at 90°C for 3 minutes on a hot plate and then at 200°C for 3 minutes in nitrogen atmosphere.

A film formation composition for forming an organic film described hereinafter was applied to the above coating film wafer by spin coating. The coating was dried at 90°C for 3 minutes on a hot plate and then at 200°C for 3 minutes in nitrogen atmosphere. The coating film thus formed was cured in a vertical furnace at 420°C under reduced pressure of 50 mTorr.

Thus, a laminate film of other silica film/silica film obtained from the film formation composition of each of the Examples and the Comparative Example/organic film having the respective film thickness of 500 nm/50 nm/500 nm.

10 Stud pins were fixed on the laminate film obtained above using an epoxy resin, and dried at 150°C for 1 hour. The stud pins were pulled out by the Sebastian method to observe the peeled surface and to evaluate the adhesion of the coating film based on the following criteria.

Good: Peeling at the interface of other silica film/silica film of the Example/organic film is less than 20%
Poor: Peeling at the interface of other silica film/silica film of the Example/organic film is 20% or more

## EXAMPLE 1

100.00 g of 15% tetramethylammonium hydroxide aqueous solution, 300.00 g of ultrapure water and 500.00 g of ethanol were mixed in a separable quartz flask. 136.22 g of methyl trimethoxysilane and 208.33 g of tetraethoxysilane were added to the flask, and the resulting mixture was stirred at 60°C for 5 hours to conduct reaction. After adding 1,500.00 g of cyclohexane to the resulting reaction solution, the resulting solution was condensed to 1,272 g (corresponding to the solid content of 10%) by evaporator. 150.00 g of 10% cyclohexanone solution of nitric acid and 4,950.00 g of cyclohexanone were added to the condensate, and the resulting mixture was filtered with a Teflon filter having a pore size of 0.2 micron to obtain a film formation composition 1 having a solid content of less than 2%.

## EXAMPLE 2

100.00 g of 10% tetramethylammonium hydroxide aqueous solution, 1,000.00 g of ultrapure water and 1,000.00 g of isopropyl alcohol were mixed in a separable quartz flask. 136.22 g of methyl trimethoxysilane and 208.33 g of tetraethoxysilane were added to the flask, and the resulting mixture was stirred at 60°C for 8 hours to conduct reaction. After adding 1,500.00 g of propylene glycol monopropyl ether to the resulting reaction solution, the resulting solution was condensed to 1,272 g (corresponding to the solid content of 10%) by evaporator. 150.00 g of 10% cyclohexanone solution of nitric acid and 4,950.00 g of γ-butyrolactone were added to the condensate, and the resulting mixture was filtered with a Teflon filter having a pore size of 0.2 micron to obtain a film formation composition 2 having a solid content of less than 2%.

**EXAMPLE 3**

100.00 g of 10% tetrapropylammonium hydroxide aqueous solution, 300.00 g of ultrapure water, 500.00 g of ethanol and 500.00 g of propylene glycol monopropyl ether were mixed in a separable quartz flask. 136.22 g of methyl trimethoxysilane and 208.33 g of tetraethoxysilane were added to the flask, and the resulting mixture was stirred at 60°C for 3 hours to conduct reaction. After adding 1,000.00 g of cyclohexane to the resulting reaction solution, the resulting solution was condensed to 1,390 g (corresponding to the solid content of 10%) by evaporator. 150.00 g of 10% cyclohexanone solution of nitric acid and 5,410.00 g of γ-butyrolactone were added to the condensate, and the resulting mixture was filtered with a Teflon filter having a pore size of 0.2 micron to obtain a film formation composition 3 having a solid content of less than 2%.

Preparation of Film Formation Composition for Other Silica Film

100.00 g of 25% tetraethylammonium hydroxide aqueous solution, 200.00 g of ultrapure water and 200.00 g of ethanol were mixed in a separable quartz flask. 81.73 g of methyl trimethoxysilane and 60.89 g of tetramethoxysilane were added to the flask, and the resulting mixture was stirred at 60°C for 3 hours to conduct reaction. After adding 1,000.00 g of propylene glycol monopropyl ether to the resulting reaction solution, the resulting solution was condensed to 435 g (corresponding to the solid content of 15%) by evaporator. 100.00 g of 10% propylene glycol monopropyl ether solution of nitric acid was added to the condensate, and the resulting mixture was filtered with a Teflon filter having a pore size of 0.2 micron to obtain a film formation composition 2 having a solid content of about 12%.

Preparation of Film Formation Composition for Organic Film

150 ml of diethyl amine, 2.1 g of dichlorobistriphenylphosphine palladium, 0.286 g of copper iodide, 600 ml of 1,2-dichloroethane and 185.72 g of 4,4'-bis(2-iodophenoxy)benzophenone were added to 1,000 ml three-necked flask equipped with a thermometer, an argon gas introducing pipe and a stirrer. 65.48 g of 4,4'-diethynyl diphenyl ether was added to the flask, and reaction was conducted at 50°C for 20 hours. Reprecipitation of the resulting reaction solution was repeated two times with 5 liters of acetic acid. The precipitate obtained was dissolved in chloroform, and washed tow times with ultrapure water. Reprecipitation was conducted with 5 liters of cyclohexane, and the precipitate formed was filtered and dried to obtain polymer A having a weight average molecular weight of 35,000. 12 g of the polymer A was dissolved in 88 g of cyclohexane, and the resulting solution was filtered with a Teflon filter having a pore size of 0.2 micron to obtain an organic film formation composition having a solid content of about 12%.

**COMPARATIVE EXAMPLE**

50.00 g of ultrapure water, 1,200.00 g of propylene glycol monoethyl ether and 10.00 g of 10 aqueous solution of maleic acid were mixed in a separable quartz flask. 136.22 g of methyl trimethoxysilane and 208.33 g of tetraethoxysilane were added to the flask, and the resulting mixture was stirred at 60°C for 5 hours to conduct reaction. The reaction solution was condensed to 1,272 g (corresponding to a solid content of 10%) by evaporator. 5,090.00 g of propylene glycol monopropyl ether was added to the condensate, and the resulting mixture was filtered with a Teflon filter having a pore size of 0.2 micron to obtain a film formation composition for comparison having a solid content of 2%.

The film formation compositions obtained in Examples 1-3 and the Comparative Example were evaluated on storage stability, dielectric constant, surface roughness and adhesion. The results obtained are shown in the Table below.

Reference Example in the Table is the embodiment that other silica film and an organic film were directly laminated without interposing a film that can exhibit the role of an adhesion layer. Further, the results of storage stability, dielectric constant, surface roughness and adhesion in Reference Example show evaluation result of the other silica film.

**TABLE**

|  | Example 1 | Example 2 | Example 3 | Comparative Example | Reference Example |
|---|---|---|---|---|---|
| Storage stability | Good | Good | Good | Good | Good |
| Dielectric constant | 2.23 | 1.98 | 2.35 | 2.78 | 2.53 |
| Surface roughness (Rmax, nm) | 12 | 21 | 11 | 5 | 7 |
| Adhesion | Good | Good | Good | Poor | Poor |

As is apparent from the results shown in the above Table, it was confirmed that the adhesion is improved in the laminates in which the film formation composition of Examples 1-3 is formed between the other silica film and the organic film. In other words, the composition for film formation according to the present invention can form a silica film having improved dielectric constant characteristics and storage stability, and also improved adhesion to other silica films and organic films.

According to the composition for film formation, the content of a product of hydrolysis and condensation as component (A) is less than 2% by weight, so that the composition can form a silica film having a large surface roughness. For this reason, in the case of, for example, laminating a silica film formed using the composition for film formation of the present invention with an organic film, adhesion can be improved by an anchor effect that the organic film enters into the silica film at the interface therebetween. Further, in the case of, for example, laminating a silica film formed using the composition for film formation of the present invention with other silica film, because the composition is similar between the silica film and the other film, adhesion therebetween can be improved. Thus, the composition for film formation according to the present invention can form a silica film having improved dielectric constant characteristics and storage stability, and also improved adhesion to other silica films and organic films.

Further, the composition for film formation of the present invention uses an organic solvent as component (B). As a result, a composition for film formation having excellent storage stability can be provided.

It should further be apparent to those skilled in the art that various changes in form and detail of the invention as shown and described above may be made. It is intended that such changes be included within the spirit and scope of the claims appended hereto.

## Claims

1. A composition for film formation comprising:

    (A) a product of hydrolysis and condensation obtained by hydrolyzing and condensing at least one silane compound selected from the group consisting of compounds represented by the following formulae (1) and (2) in the presence of an alkali catalyst:

    $$R_aSi(OR^1)_{4-a} \qquad (1)$$

    wherein R represents hydrogen atom, fluorine atom, or a monovalent organic group; $R^1$ represents a monovalent organic group; and a is an integer of 0 - 2;

    $$R^2_b(R^3O)_{3-b}Si-(R^6)_d-Si(OR^4)_{3-c}R^5_c \qquad (2)$$

    wherein $R^2$ to $R^5$ may be the same or different and each represents a monovalent organic group; b and c may be the same or different and each is a number of 0 - 2; $R^6$ represents oxygen atom, phenylene group, or a group represented by $-(CH_2)_n-$, wherein n is an integer of 1 - 6; and d is 0 or 1; and
    (B) an oxygen-containing organic solvent,

    wherein the content of the product of hydrolysis and condensation (A) is less than 2 % by weight based on the weight of the composition.

2. The composition as claimed in claim 1, wherein the alkali catalyst is at least one selected from the group consisting of alkali metal hydroxides, ammonia, alkylamines and tetralakylamine salts.

3. The composition as claimed in claim 1, wherein the oxygen-containing organic solvent has a boiling point of 100 - 200°C.

4. The composition as claimed in claim 1, wherein the oxygen-containing organic solvent is at least one selected from the group consisting of alkylene glycols, alkylene glycol monoalkyl ethers, alkylene glycol dialkyl ethers, alkylene glycol monoalkyl acetates, cyclic ethers and cyclcic ketones.

5. A method for preparing the composition for film formation according to claim 1 comprising;

    hydrolyzing and condensing at least one silane compound selected from the group consisting of compounds represented by the following formulae (1) and (2) in the presence of an alkali catalyst, water and an alcohol having 3 or less carbon atoms:

$$R_aSi(OR^1)_{4-a} \qquad (1)$$

wherein R represents hydrogen atom, fluorine atom, or a monovalent organic group; $R^1$ represents a monovalent organic group; and a is an integer of 0 - 2 ;

$$R^2_b(R^3O)_{3-b}Si-(R^6)_d-Si(OR^4)_{3-c}R^5_c \qquad (2)$$

wherein $R^2$ to $R^5$ may be the same or different and each represents a monovalent organic group; b and c may be the same or different and each is a number of 0 - 2; $R^6$ represents oxygen atom, phenylene group, or a group represented by $-(CH_2)_n-$, wherein n is an integer of 1 - 6; and d is 0 or 1; and adding an oxygen-containing organic solvent to the resulting product.

6. A method for preparing the composition for film formation according to claim 1 comprising:

hydrolyzing and condensing at least one silane compound selected from the group consisting of compounds represented by the following formulae (1) and (2) in the presence of an alkali catalyst, water, an alcohol having 3 or less carbon atoms, and an oxygen-containing organic solvent:

$$R_aSi(OR^1)_{4-a} \qquad (1)$$

wherein R represents hydrogen atom, fluorine atom, or a monovalent organic group; $R^1$ represents a monovalent organic group; and a is an integer of 0 - 2;

$$R^2_b(R^3O)_{3-b}Si-(R^6)_d-Si(OR^4)_{3-c}R^5_c \qquad (2)$$

wherein $R^2$ to $R^5$ may be the same or different and each represents a monovalent organic group; b and c may be the same or different and each is a number of 0 - 2; $R^6$ represents oxygen atom, phenylene group, or a group represented by $-(CH_2)_n-$, wherein n is an integer of 1 - 6; and d is 0 or 1.

7. A method for forming an insulating film comprising:

a) applying a composition for film formation comprising:

(A) a product of hydrolysis and condensation obtained by hydrolyzing and condensing at least one silane compound selected from the group consisting of compounds represented by the following formulae (1) and (2) in the presence of an alkali catalyst:

$$R_aSi(OR^1)_{4-a} \qquad (1)$$

wherein R represents hydrogen atom, fluorine atom, or a monovalent organic group; $R^1$ represents a monovalent organic group; and a is an integer of 0 - 2;

$$R^2_b(R^3O)_{3-b}Si-(R^6)_d-Si(OR^4)_{3-c}R^5_c \qquad (2)$$

wherein $R^2$ to $R^5$ may be the same or different and each represents a monovalent organic group; b and c may be the same or different and each is a number of 0 - 2; $R^6$ represents oxygen atom, phenylene group, or a group represented by $-(CH_2)_n-$, wherein n is an integer of 1 - 6; and d is 0 or 1; and
(B) an oxygen-containing organic solvent,

wherein the content of the product of hydrolysis and condensation (A) is less than 2 % by weight based on the weight of the composition
to a silica insulating film, and drying the resulting coating film, and
b) forming an organic insulating film on the film obtained in the above step a).

8. The method as claimed in claim 7, wherein the silica insulating film is a film obtained by coating a coating-type polysiloxane solution and heating the same, or a film obtained by CVD method.

**Patentansprüche**

1. Zusammensetzung für die Filmherstellung, die die nachstehenden Bestandteile umfasst:

(A) das Produkt einer Hydrolyse und Kondensation, das in Gegenwart eines Alkalikatalysators durch Hydrolysieren und Kondensieren von mindestens einer Silanverbindung erhalten wurde, die aus der Gruppe ausgewählt ist, die aus Verbindungen besteht, die durch die nachstehenden Formeln (1) und (2) wiedergegeben werden:

$$R_aSi(OR^1)_{4-a} \qquad (1)$$

worin R für ein Wasserstoffatom, ein Fluoratom oder eine einwertige organische Gruppe steht; $R^1$ für eine einwertige organische Gruppe steht; und a eine ganze Zahl von 0 bis 2 ist;

$$R^2_b(R^3O)_{3-b}Si-(R^6)_d-Si(OR^4)_{3-c}R^5_c \qquad (2)$$

worin $R^2$ bis $R^5$ gleich oder verschieden sein können und jedes eine einwertige organische Gruppe darstellt; b und c gleich oder verschieden sein können und jedes für eine Zahl von 0 bis 2 steht; $R^6$ für ein Sauerstoffatom, eine Phenylengruppe oder eine Gruppe steht, die durch $-(CH_2)_n-$ wiedergegeben wird, worin n eine ganze Zahl von 1 bis 6 ist;
und d für 0 oder 1 steht; und
(B) ein sauerstoffhaltiges organisches Lösungsmittel,

wobei der Gehalt an dem Produkt einer Hydrolyse und Kondensation (A) weniger als 2 Gewichts-% beträgt, bezogen auf das Gewicht der Zusammensetzung.

2. Zusammensetzung nach Anspruch 1, wobei der Alkalikatalysator mindestens einer ist, der aus der Gruppe ausgewählt ist, die aus Alkalimetallhydroxiden, Ammoniak, Alkylaminen und Tetraalkylaminsalzen besteht.

3. Zusammensetzung nach Anspruch 1, in der das sauerstoffhaltige organische Lösungsmittel einen Siedepunkt von 100 bis 200 °C aufweist.

4. Zusammensetzung nach Anspruch 1, in der das sauerstoffhaltige organische Lösungsmittel mindestens eines ist, das aus der Gruppe ausgewählt ist, die aus Alkylenglykolen, Alkylenglykol-monoalkylethern, Alkylenglykol-dialkylethern, Alkylenglykol-monoalkylacetaten, cyclischen Ethern und cyclischen Ketonen besteht.

5. Verfahren zur Herstellung der Zusammensetzung für die Filmherstellung nach Anspruch 1, das die nachstehenden Schritte umfasst:

Hydrolysieren und Kondensieren mindestens einer Silanverbindung, die aus der Gruppe ausgewählt ist, die aus Verbindungen besteht, die durch die nachstehenden Formeln (1) und (2) wiedergegeben werden, in Gegenwart eines Alkalikatalysators, Wassers und eines Alkohols mit 3 oder weniger Kohlenstoffatomen:

$$R_aSi(OR^1)_{4-a} \qquad (1)$$

worin R für ein Wasserstoffatom, ein Fluoratom oder eine einwertige organische Gruppe steht; $R^1$ für eine einwertige organische Gruppe steht; und a eine ganze Zahl von 0 bis 2 ist;

$$R^2_b(R^3O)_{3-b}Si-(R^6)_d-Si(OR^4)_{3-c}R^5_c \qquad (2)$$

worin $R^2$ bis $R^5$ gleich oder verschieden sein können und jedes eine einwertige organische Gruppe darstellt; b und c gleich oder verschieden sein können und jedes für eine Zahl von 0 bis 2 steht; $R^6$ für ein Sauerstoffatom, eine Phenylengruppe oder eine Gruppe steht, die durch $-(CH_2)_n-$ wiedergegeben wird, worin n eine ganze Zahl von 1 bis 6 ist; und d für 0 oder 1 steht; und
Zugabe eines sauerstoffhaltigen organischen Lösungsmittels zu dem resultierenden Produkt.

**6.** Verfahren zur Herstellung der Zusammensetzung für die Filmherstellung nach Anspruch 1, das die nachstehenden Schritte umfasst:

Hydrolysieren und Kondensieren mindestens einer Silanverbindung, die aus der Gruppe ausgewählt ist, die aus Verbindungen besteht, die durch die nachstehenden Formeln (1) und (2) wiedergegeben werden, in Gegenwart eines Alkalikatalysators, Wassers, eines Alkohols mit 3 oder weniger Kohlenstoffatomen und eines sauerstoffhaltigen organischen Lösungsmittels:

$$R_a Si(OR^1)_{4-a} \qquad (1)$$

worin R für ein Wasserstoffatom, ein Fluoratom oder eine einwertige organische Gruppe steht; $R^1$ für eine einwertige organische Gruppe steht; und a eine ganze Zahl von 0 bis 2 ist;

$$R^2_b(R^3O)_{3-b}Si\text{-}(R^6)_d\text{-}Si(OR^4)_{3-c}R^5_c \qquad (2)$$

worin $R^2$ bis $R^5$ gleich oder verschieden sein können und jedes eine einwertige organische Gruppe darstellt; b und c gleich oder verschieden sein können und jedes für eine Zahl von 0 bis 2 steht; $R^6$ für ein Sauerstoffatom, eine Phenylengruppe oder eine Gruppe steht, die durch -$(CH_2)_n$- wiedergegeben wird, worin n eine ganze Zahl von 1 bis 6 ist; und d für 0 oder 1 steht.

**7.** Verfahren zur Herstellung eines Isolierfilms, das die nachstehenden Schritte umfasst:

a) Aufbringen einer Zusammensetzung für die Filmherstellung, die die nachstehenden Bestandteile umfasst:

(A) das Produkt einer Hydrolyse und Kondensation, das in Gegenwart eines Alkalikatalysators durch Hydrolysieren und Kondensieren von mindestens einer Silanverbindung erhalten wurde, die aus der Gruppe ausgewählt ist, die aus Verbindungen besteht, die durch die nachstehenden Formeln (1) und (2) wiedergegeben werden:

$$R_a Si(OR^1)_{4-a} \qquad (1)$$

worin R für ein Wasserstoffatom, ein Fluoratom oder eine einwertige organische Gruppe steht; $R^1$ für eine einwertige organische Gruppe steht; und a eine ganze Zahl von 0 bis 2 ist;

$$R^2_b(R^3O)_{3-b}Si\text{-}(R^6)_d\text{-}Si(OR^4)_{3-c}R^5_c \qquad (2)$$

worin $R^2$ bis $R^5$ gleich oder verschieden sein können und jedes eine einwertige organische Gruppe darstellt; b und c gleich oder verschieden sein können und jedes für eine Zahl von 0 bis 2 steht; $R^6$ für ein Sauerstoffatom, eine Phenylengruppe oder eine Gruppe steht, die durch -$(CH_2)_n$- wiedergegeben wird, worin n eine ganze Zahl von 1 bis 6 ist; und d für 0 oder 1 steht; und
(B) ein sauerstoffhaltiges organisches Lösungsmittel,

wobei der Gehalt an dem Produkt einer Hydrolyse und Kondensation (A) weniger als 2 Gewichts-% beträgt, bezogen auf das Gewicht der Zusammensetzung,
auf einen Siliciumdioxid-Isolierfilm, Trocknen des resultierenden Beschichtungsfilms, und
b) Bildung eines organischen Isolierfilms auf dem im vorstehenden Schritt a) erhaltenen Film.

**8.** Verfahren nach Anspruch 7, in dem es sich bei dem Siliziumdioxid-Isolierfilm um einen Film handelt, der durch Aufbringen einer Polysiloxanlösung vom Beschichtungs-Typ und Erwärmen derselben erhalten wurde, oder um einen Film handelt, der mittels des CVD-Verfahrens erhalten wurde.

**Revendications**

**1.** Composition pour la formation de film comprenant :

(A) un produit d'hydrolyse et de condensation obtenu en hydrolysant et en condensant au moins un composé silane choisi dans le groupe constitué de composés représentés par les formules (1) et (2) suivantes en présence d'un catalyseur alcalin :

$$R_aSi(OR^1)_{4-a} \qquad (1)$$

dans laquelle R représente un atome d'hydrogène, un atome de fluor, ou un groupe organique monovalent ; $R^1$ représente un groupe organique monovalent, et a est un entier de 0 à2;

$$R^2{}_b(R^3O)_{3-b}Si\text{-}(R^6)_d\text{-}Si\,(OR^4)_{3-c}R^5{}_c \qquad (2)$$

dans laquelle $R^2$ à $R^5$ peuvent être identiques ou différents et chacun représente un groupe organique monovalent ; b et c peuvent être identiques ou différents et chacun est un nombre de 0 à 2 ; $R^6$ représente un atome d'oxygène, un groupe phénylène, ou un groupe représenté par $-(CH_2)_n-$, dans lequel n est un entier de 1 à 6 ; et d vaut 0 ou 1 ; et
(B) un solvant organique contenant de l'oxygène,

dans laquelle la teneur du produit d'hydrolyse de condensation (A) est inférieure à 2 % en poids sur la base du poids de la composition.

2. Composition selon la revendication 1, dans laquelle le catalyseur alcalin est au moins un élément choisi dans le groupe constitué d'hydroxydes de métal alcalin, d'ammoniaque, d'alkylamines et de sels de tétraalkylamine.

3. Composition selon la revendication 1, dans laquelle le solvant organique contenant de l'oxygène a un point d'ébullition de 100 à 200 °C.

4. Composition selon la revendication 1, dans laquelle le solvant organique contenant de l'oxygène est au moins un élément choisi dans le groupe constitué des alkylène glycols, des alkylène glycol monoalkyl éthers, des alkylène glycol dialkyl éthers, des monoalkyl acétates d'alkylène glycol, des éthers cycliques et des cétones cycliques.

5. Procédé de préparation de la composition pour la formation de film selon la revendication 1, comprenant les étapes consistant à :

   hydrolyser et condenser au moins un composé silane choisi dans le groupe constitué de composés représentés par les formules (1) et (2) suivantes en présence d'un catalyseur alcalin, d'eau et d'un alcool ayant 3 atomes de carbone ou moins :

$$R_aSi(OR^1)_{4-a} \qquad (1)$$

   dans laquelle R représente un atome d'hydrogène, un atome de fluor, ou un groupe organique monovalent ; $R^1$ représente un groupe organique monovalent, et a est un entier de 0 à2;

$$R^2{}_b(R^3O)_{3-b}Si\text{-}(R^6)_d\text{-}Si\,(OR^4)_{3-c}R^5{}_c \qquad (2)$$

   dans laquelle $R^2$ à $R^5$ peuvent être identiques ou différents et chacun représente un groupe organique monovalent ; b et c peuvent être identiques ou différents et chacun est un nombre de 0 à 2 ; $R^6$ représente un atome d'oxygène, un groupe phénylène, ou un groupe représenté par $-(CH_2)_n-$, dans lequel n est un entier de 1 à 6 ; et d vaut 0 ou 1 ; et
   ajouter un solvant organique contenant de l'oxygène au produit résultant.

6. Procédé de préparation de la composition pour la formation de film selon la revendication 1, comprenant les étapes consistant à :

   hydrolyser et condenser au moins un composé silane choisi dans le groupe constitué de composés représentés par les formules (1) et (2) suivantes en présence d'un catalyseur alcalin, d'eau, d'un alcool ayant 3 atomes de carbone ou moins, et un solvant organique contenant de l'oxygène :

$$R_aSi(OR^1)_{4-a} \qquad (1)$$

   dans laquelle R représente un atome d'hydrogène, un atome de fluor, ou un groupe organique monovalent ;

$R^1$ représente un groupe organique monovalent, et a est un entier de 0 à2;

$$R^2{}_b(R^3O)_{3-b}Si\text{-}(R^6)_d\text{-}Si\ (OR^4)_{3-c}R^5{}_c \qquad (2)$$

dans laquelle $R^2$ à $R^5$ peuvent être identiques ou différents et chacun représente un groupe organique monovalent ; b et c peuvent être identiques ou différents et chacun est un nombre de 0 à 2 ; $R^6$ représente un atome d'oxygène, un groupe phénylène, ou un groupe représenté par $-(CH_2)_n-$, dans lequel n est un entier de 1 à 6 ; et d vaut 0 ou 1 ;

7.  Procédé de formation d'un film isolant comprenant les étapes consistant à :

a) appliquer une composition pour la formation de film comprenant :

(A) un produit d'hydrolyse et de condensation obtenu en hydrolysant et en condensant au moins un composé silane choisi dans le groupe constitué de composés représentés par les formules (1) et (2) suivantes en présence d'un catalyseur alcalin :

$$R_aSi(OR^1)_{4-a} \qquad (1)$$

dans laquelle R représente un atome d'hydrogène, un atome de fluor, ou un groupe organique monovalent ; $R^1$ représente un groupe organique monovalent, et a est un entier de 0 à2;

$$R^2{}_b(R^3O)_{3-b}Si\text{-}(R^6)_d\text{-}Si\ (OR^4)_{3-c}R^5{}_c \qquad (2)$$

dans laquelle $R^2$ à $R^5$ peuvent être identiques ou différents et chacun représente un groupe organique monovalent ; b et c peuvent être identiques ou différents et chacun est un nombre de 0 à 2 ; $R^6$ représente un atome d'oxygène, un groupe phénylène, ou un groupe représenté par $-(CH_2)_n-$, dans lequel n est un entier de 1 à 6 ; et d vaut 0 ou 1 ; et
(B) un solvant organique contenant de l'oxygène,

dans laquelle la teneur du produit d'hydrolyse de condensation (A) est inférieure à 2 % en poids sur la base du poids de la composition
à un film isolant en silice, et à sécher le film de revêtement résultant, et
b) former un film isolant organique sur le film obtenu dans l'étape a) ci-dessus.

8.  Procédé selon la revendication 7, dans lequel le film isolant en silice est un film obtenu en revêtant une solution de poly(siloxane) de type revêtement et en chauffant celle-ci, ou un film obtenu par procédé CVD (dépôt chimique en phase vapeur).

**EP 1 535 976 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000256621 A